# EUROPÄISCHE PATENTSCHRIFT

(11) **EP 2 677 281 B1**
(45) Veröffentlichungstag und Bekanntmachung des Hinweises auf die Patenterteilung: **06.08.2014**
(21) Anmeldenummer: 12173211.9
(22) Anmeldetag: 22.06.2012
(51) Int. Cl.: G01D 5/34, G01J 4/04, G02B 5/30, H01L 31/0216

(54) **Optoelektronisches Sensorelement**
Optoelectronic sensor element
Elément de capteur opto-électronique

(43) Veröffentlichungstag der Anmeldung: 25.12.2013
(73) Patentinhaber: SICK STEGMANN GmbH, 78166 Donaueschingen (DE)
(72) Erfinder: Mutschler, Reinhold, 78056 Villingen-Schwenningen (DE); Zwölfer, Ulrich, 79341 Kenzingen (DE)
(74) Vertreter: Ludewigt, Christoph

(56) Entgegenhaltungen:
- EP-A1- 1 972 909
- JP-A- 2011 112 786
- US-A1- 2008 186 491

## Beschreibung

Die Erfindung betrifft ein optoelektronisches Sensorelement gemäß dem Oberbegriff des Patentanspruchs 1.

Bekannt sind optoelektronische Sensorelemente mit wenigstens einem Empfangselement, vor welchem eine polarisierende Struktur angeordnet ist, welche aus einem elektrisch leitfähigen Material gefertigt ist.

Beispielsweise offenbart die DE 10 2008 014 334 B4 einen integrierten Polarisationssensor mit einem Polarisationssensorelement, wobei das Polarisationssensorelement einen optoelektronischen Sensor und eine Polarisationsfilterstruktur mit wenigstens einer strukturierten Metallschicht aufweist.

Die EP 1 972 909 A1 offenbart einen Lumineszenzsensor mit einem metallischen Wire-Grid Polarisationsfilter, welches auch als Heizelement dient, wozu das Wire-Grid an eine Spannungsversorgung angeschlossen ist.

Die US 2008/0186491 offenbart einen Drehgeber mit einem metallischen Polarisationsfilter.

Die JP 2011 112 786 A1 offenbart ein Flüssigkristalldisplay mit einem geerdeten Wire-Grid-Polaristor zur Abschirmung.

Optische Empfangselemente, insbesondere Photodiodenstrukturen in optischen Sensoren, sind häufig empfindlich gegenüber kapazitiver Einkopplung von elektrischen Störungen, wodurch der Einsatz derartiger Sensoren in einem Umfeld mit hohem Störpotential erschwert wird.

Die Aufgabe der Erfindung besteht daher darin, ein optoelektronisches Sensorelement bereitzustellen, welches vielseitig einsetzbar ist und insbesondere in einem Umfeld mit hohem elektrischen Störpotential verwendet werden kann.

Die Aufgabe der Erfindung wird gelöst durch ein optoelektronisches Sensorelement mit den Merkmalen des Patentanspruchs 1.

Vorteilhafte Ausgestaltungen und Weiterbildungen der Erfindung sind in den abhängigen Ansprüchen angegeben.

Das erfindungsgemäße optoelektronische Sensorelement mit wenigstens einem Empfangselement, vor welchem eine polarisierende Struktur angeordnet ist, welche aus einem elektrisch leitfähigen Material gefertigt ist, zeichnet sich dadurch aus, dass die polarisierende Struktur einen Kontaktanschluss zum Anlegen eines definierten Potentials aufweist und dass die polarisierende Struktur als Abschirmung des Sensorelements ausgebildet ist. Dadurch wird es ermöglicht, dass die für die Polarisation ohnehin erforderlichen und vorhandenen metallischen Gitterstrukturen zusätzlich zur Abschirmung gegen elektrische Störfelder oder elektromagnetische Störungen benutzt werden, so dass einerseits die elektromagnetische Verträglichkeit durch die Abschirmung verbessert wird, dies jedoch andererseits ohne einen signifikanten Anteil an zusätzlichen Bauelementen realisierbar ist.

Vorzugsweise ist die polarisierende Struktur aus elektrisch leitfähigen Streifen ausgebildet, was eine einfache und kostengünstige Herstellung ermöglicht.

Besonders bevorzugt ist die polarisierende Struktur als Drahtgitter-Polarisator, welcher auch als Wire-Grid-Polarisator bezeichnet wird, ausgebildet, was die Herstellung vereinfacht. Die Wire-Grid-Strukturen können direkt im Herstellungsprozess als Metallisierungsebene des Sensors realisiert werden und erfordern auf diese Weise kein zusätzliches Bauteil, sondern sind unmittelbar in den Sensor integriert. Alternativ können die Wire-Grid-Strukturen auch auf das zur Abdeckung des Sensors häufig verwendete Glas aufgebracht werden, das über dem Empfangselement des Sensors angeordnet und relativ zu diesem justiert ist.

Vorzugsweise weist der Drahtgitter-Polarisator leitende Streifen auf, deren Breite kleiner als die Wellenlänge des Lichts ist und in einem Raster angeordnet ist, das etwa doppelt so groß ist, wie die Streifenbreite, was eine Verwendung des optoelektronisches Sensorelements insbesondere im Zusammenhang mit sichtbarem Licht ermöglicht.

Vorzugsweise weist der Drahtgitter-Polarisator Metallstreifen mit einer Breite von etwa 200 nm auf, welche in einem Raster von etwa 400 nm angeordnet sind, was eine Verwendung des optoelektronisches Sensorelements insbesondere im Zusammenhang mit sichtbarem Licht ermöglicht.

Vorzugsweise ist die polarisierende Struktur aus Aluminium oder einer Aluminiumlegierung gefertigt, was eine einfache und kostengünstige Herstellung ermöglicht.

Besonders bevorzugt ist der Kontaktanschluss elektrisch leitend mit dem Massepotential verbunden, um auf diese Weise eine einfache und zuverlässige Abschirmung bereitstellen zu können.

Gemäß einer bevorzugten Ausführungsform der Erfindung ist der Kontaktanschluss als Anschlussfläche ausgebildet. Eine derartige Anschlussfläche erlaubt es, zum Zweck der elektrischen Abschirmung die polarisierende Struktur zu kontaktieren und beispielsweise mit der Masse des Sensorelements zu verbinden. Dadurch kann insbesondere ein Faradayscher Käfig gebildet werden, der die Störfestigkeit des optoelektronischen Sensorelements erhöht.

Gemäß einer bevorzugten Ausführungsform der Erfindung ist wenigstens eine Gruppe mit wenigstens zwei Empfangselementen vorhanden, vor welchen jeweils eine polarisierende Struktur angeordnet ist, wobei die Polarisationsebenen der Empfangselemente in der Gruppe jeweils gegeneinander verdreht sind, vorzugsweise um 180°/n, wobei n die Zahl der Empfangselemente der Gruppe ist. Die Verwendung von wenigstens zwei Empfangselementen, vorzugsweise einer Vielzahl von Empfangselementen, verbessert die Genauigkeit der Messung des optoelektronischen Sensorelements, da eine Mittelung über die verschiedenen optischen Kanäle erfolgen kann. Die Anzahl der Empfangselemente mit unterschiedlicher Polarisationsebene bestimmt dabei insbesondere die Anzahl der optischen Kanäle. Grundsätzlich können die Polarisationsebenen der Empfangselemente um beliebige Winkel gegeneinander verdreht sein. Gemäß einer vorteilhaften Ausgestaltung der Erfindung sind die Polarisationsebenen der Empfangselemente jeweils um 180°/n gegeneinander verdreht, wobei n die Anzahl der Empfangselemente ist. Dadurch ergibt sich insbesondere eine gleichmäßige Mittelung über alle Polarisationsrichtungen. Werden mehrere Gruppen von Empfangselementen verwendet, kann bei Verwendung mehrfacher Kanäle die Auflösung durch statistische Mittelungen zusätzlich verbessert werden.

Besonders bevorzugt kommt ein erfindungsgemäßes optoelektronisches Sensorelement in einer Vorrichtung zur Messung des Drehwinkels zweier relativ zueinander um eine Drehachse rotierender Objekte, mit einer dem einen Objekt zugeordneten Lichtquelle, die unpolarisiertes Licht aussendet, mit einem Polarisator, wobei sich die Lichtquelle und der Polarisator in Abhängigkeit vom Drehwinkel relativ zueinander drehen, und mit einem Empfänger, der die durch den Polarisator durchtretende oder reflektierte Lichtintensität misst, um ein drehwinkelabhängiges Signal zu erzeugen, zur Anwendung.

Vorzugsweise sind bei der Vorrichtung zur Messung des Drehwinkels zweier relativ zueinander um eine Drehachse rotierender Objekte die Lichtquelle und der Empfänger mit der gleichen elektrischen Modulationsfrequenz beaufschlagbar, um unempfindlicher gegen elektrische Offsets, beispielsweise durch Störlicht oder Dunkelströme, zu werden.

Vorzugsweise ist hinter dem Polarisator ein Spiegel angeordnet, welcher senkrecht zur Drehachse angeordnet ist, welcher sich besonders bevorzugt mit dem Polarisator dreht. Dies kann einen kompakten Aufbau ermöglichen.

Besonders bevorzugt ist im Strahlengang ein Strahlteiler angeordnet, welcher insbesondere nicht polarisierend ausgebildet ist, und welcher dazu vorgesehen ist, einerseits seitlich Licht aus- oder einkoppeln zu können und andererseits axiale Toleranzen ausgleichen zu können.

Die Erfindung wird anhand der nachfolgenden Figuren ausführlich erläutert. Es zeigt:
- Figur 1: eine schematische Darstellung eines optoelektronisches Sensorelements mit einem Empfangselement in einer Ausführungsform der Erfindung,
- Figur 2: eine Draufsicht auf eine Ausführungsform eines optoelektronischen Sensorelements mit vier Empfangselementen,
- Figur 3: eine schematische Darstellung einer Vorrichtung zur Messung des Drehwinkels zweier relativ zueinander rotierender Objekte in einer Ausführungsform der Erfindung,
- Figur 4: eine schematische Darstellung einer Vorrichtung zur Messung des Drehwinkels zweier relativ zueinander rotierender Objekte in einer weiteren Ausführungsform der Erfindung und
- Figur 5: eine schematische Darstellung der Polarisationsebenen der Lichtwege der Vorrichtung gemäß Figur 4.

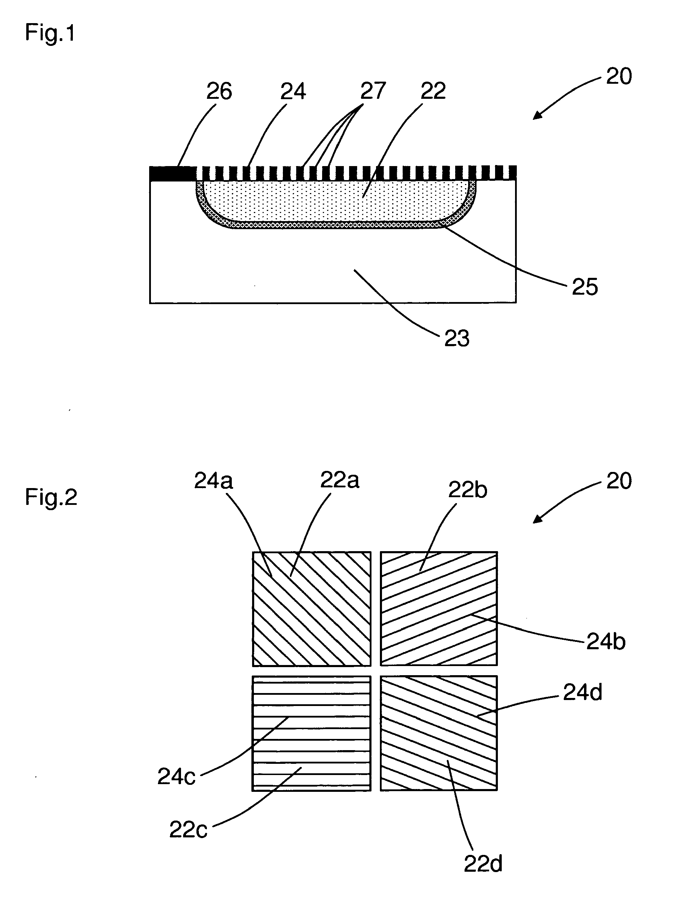

Figur 1 zeigt eine schematische Darstellung eines Längsschnitts durch ein Ausführungsbeispiel eines Sensorelements 20, welches ein Empfangselement 22 aufweist, das insbesondere als Photodiode ausgebildet ist. Das Empfangselement 22 ist dabei insbesondere auf einem als P-Substrat ausgebildeten Träger 23 durch einen pn-Übergang 25 von dem P-Substrat getrennt angeordnet. Vor dem Empfangselement 22, d. h. auf der dem einfallenden Licht zugewandten Seite des Empfangselements 22, ist eine polarisierende Struktur 24 angeordnet. Die polarisierende Struktur 24 ist insbesondere aus Metall, beispielsweise aus Aluminium oder einer Aluminiumlegierung, gefertigt.

Die polarisierende Struktur 24 weist beispielsweise mehrere zueinander beabstandete und in einem Raster angeordnete elektrisch leitfähige Streifen 27 auf und kann beispielsweise als Drahtgitter-Polarisator ausgebildet sein. Der Drahtgitter-Polarisator kann beispielsweise Metallstreifen 27 mit einer Breite von 200 nm aufweisen, welche in einem Raster von 400 nm angeordnet sind, so dass der Drahtgitter-Polarisator insbesondere mit sichtbarem Licht verwendet werden kann.

Die polarisierende Struktur 24 weist einen Kontaktanschluss 26 auf, der gemäß der vorliegenden Ausführungsform als Anschlussfläche ausgebildet ist, und über welchen die polarisierende Struktur 24 elektrisch leitend mit einem definierten Potential, beispielsweise mit dem Massepotential verbindbar ist. Der Kontaktanschluss 26 kann auch einstückig mit einem auf einem definierten Potential liegenden Bauteil verbunden sein oder mittels eines Drahts, Kabels oder ähnlichem mit einem definierten Potential verbindbar sein.

Wie in Figur 2 dargestellt, kann das optoelektronische Sensorelement 20 mehrere Empfangselemente, beispielsweise vier Empfangselemente 22a, 22b, 22c, 22d aufweisen. Jedes der Empfangselemente 22a, 22b, 22c, 22d weist eine polarisierende Struktur 24a, 24b, 24c, 24d auf, wobei die Polarisationsebenen der verschiedenen Empfangselemente 22a, 22b, 22c, 22d jeweils gegeneinander verdreht sind, beispielsweise um 180°/n, im vorliegenden Ausführungsbeispiel somit um 45°. Die Verwendung von wenigstens zwei Empfangselementen 22a, 22b, 22c, 22d führt zu der entsprechenden Zahl von optischen Kanälen, die ausgewertet und gegebenenfalls gemittelt werden können, um die Messgenauigkeit des optoelektronischen Sensorelements 20 zu verbessern.

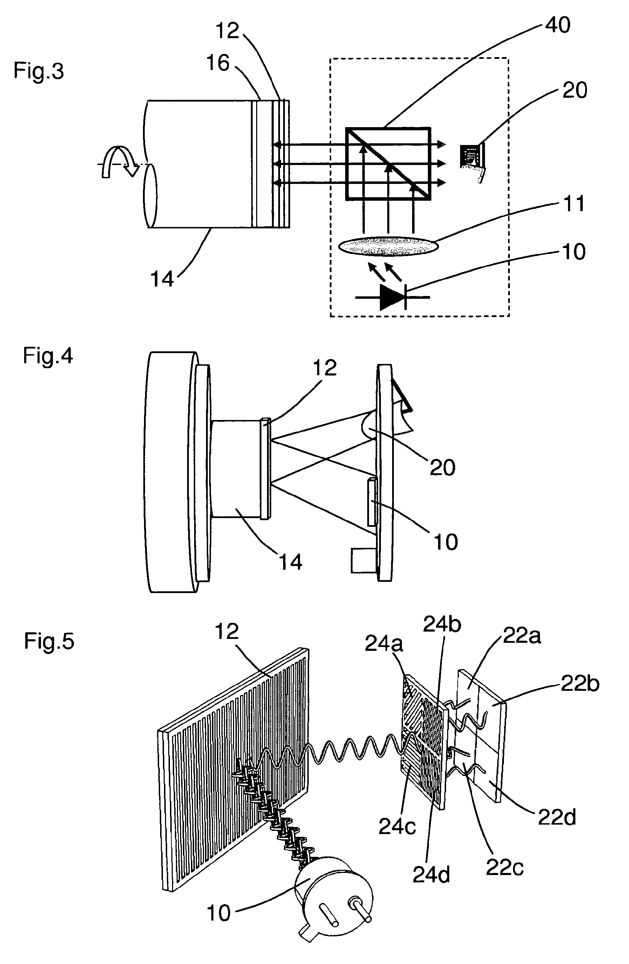

Insbesondere kommt das optoelektronische Sensorelement 22 in einer Vorrichtung zur Messung des Drehwinkels zweier relativ zueinander um eine Drehachse rotierender Objekte zur Anwendung. Ein Ausführungsbeispiel einer derartigen Vorrichtung zur Messung des Drehwinkels zeigt Figur 3.

Figur 3 zeigt schematisch den Strahlengang einer Vorrichtung zur Messung des Drehwinkels zweier relativ zueinander rotierender Objekte mit einer Lichtquelle 10, welche als unpolarisierte Lichtquelle 10 ausgebildet ist, beispielsweise als LED. Das von der Lichtquelle 10 abgestrahlte Licht wird durch eine Linse 11 kollimiert und mithilfe des Polarisators 12 linear polarisiert. Dabei ist der Polarisator 12 an einer rotierenden Welle 14 angeordnet. Zwischen dem Polarisator 12 und der Welle 14 ist ein Spiegel 16 angeordnet, der das den Polarisator 12 durchdringende und von diesem polarisierte Licht durch den Polarisator 12 zurückreflektiert. Alternativ kann auch der Polarisator 12 reflektierend ausgebildet sein, so dass der Spiegel 16 entfallen kann. Der Polarisator 12 kann als Drahtgitter-Polarisator ausgebildet sein.

Wie in Figur 3 dargestellt, ist die Lichtquelle 10 seitlich angeordnet. Das von der Lichtquelle 10 ausgesandte Licht wird von einem Strahlteiler 40 eingekoppelt. Das von dem Spiegel 16 reflektierte Licht trifft nach Durchgang durch den Strahlteiler 40 auf das optoelektronische Sensorelement 20, welches beispielsweise wie in Figur 1 oder 2 dargestellt ausgebildet sein kann. Die Positionen der Lichtquelle 10 und des Empfängers 20 können selbstverständlich vertauscht werden.

Eine wie in Figur 3 dargestellte Anordnung weist den Vorteil auf, dass ein axialer Strahlverlauf ermöglicht wird, was dazu führt, dass axiale Toleranzen zwischen der Lichtquelle 10 und der Welle 14 ausgeglichen werden können. Mit der Vorrichtung gemäß Figur 3 kann der Drehwinkel zweier relativ zueinander rotierender Objekte wie folgt bestimmt werden, wobei vorliegend lediglich ein Objekt rotierend ausgebildet ist, nämlich die Welle 14, beispielsweise die Welle 14 eines Motors, wobei der Drehwinkel der Welle 14 in Bezug zu einem feststehenden Teil, beispielsweise dem Motorgehäuse oder einem feststehenden Maschinenteil, ermittelt werden soll. Die Lichtquelle 10 ist feststehend angeordnet und kann beispielsweise dem feststehenden Teil zugeordnet sein. Abhängig vom Drehwinkel der rotierenden Welle 14 ändert sich die Intensität des Lichts, welche in dem Empfangselement 22 detektiert wird, und ist maximal, wenn die Polarisationsebene des Polarisators 12 mit der Polarisationsebene der polarisierenden Struktur 24 des Empfangselements 22 übereinstimmt, und minimal, wenn die Polarisationsebene des Polarisators 12 senkrecht zur Polarisationsebene der polarisierenden Struktur 24 des Empfangselements 22 steht. Der Drehwinkel kann somit ohne weitere Hilfsmittel über eine halbe Drehung der Welle 14 gemessen werden. Die Verwendung von mehreren Empfangselementen 22a, 22b, 22c, 22d führt zu einer entsprechenden Zahl von optischen Kanälen, die ausgewertet werden können und gegebenenfalls gemittelt werden können, wodurch die Genauigkeit der Messung des Drehwinkels verbessert werden kann.

Dadurch, dass die polarisierende Struktur 24 des optoelektronischen Sensorelements 20 als Abschirmung ausgebildet ist, wird die elektromagnetische Verträglichkeit des optoelektronischen Sensorelements verbessert. Die polarisierende Struktur 24 kann beispielsweise direkt im Herstellungsprozess als Metallisierungsebene des optoelektronischen Sensorelements ausgebildet sein, so dass kein zusätzliches Bauteil erforderlich ist, um eine Abschirmung zu realisieren, was den Aufbau des optoelektronischen Sensorelements vereinfacht und eine kostengünstige Herstellung ermöglicht.

Figur 4 zeigt eine alternative Ausführungsform einer Vorrichtung zur Messung des Drehwinkels zweier relativ zueinander rotierender Objekte, welche sich von der in Figur 3 dargestellten Ausführungsform lediglich dadurch unterscheidet, dass sowohl die Lichtquelle 10 als auch das optoelektronische Sensorelement 20 im Winkel zur Drehachse angeordnet sind, wodurch der Strahlteiler 4 der Vorrichtung gemäß Figur 3 entfallen kann.

Figur 5 zeigt schematisch die Darstellung der Polarisationsebenen der Lichtwege der in Figur 4 dargestellten Vorrichtung. Die Lichtquelle 10 strahlt unpolarisiertes Licht ab, welches in dem Polarisator 12 linier polarisiert wird. Die gegeneinander verdrehten Polarisationsebenen der polarisierenden Strukturen 24a, 24b, 24c, 24d der Empfangselemente 22a, 22b, 22c, 22d bewirken eine unterschiedliche Intensität in den einzelnen Empfangselementen 22a, 22b, 22c, 22d und die Bildung mehrerer optischer Kanäle, die unabhängig voneinander ausgewertet werden können.

### Bezugszeichenliste

- 10: Lichtquelle
- 11: Linse
- 12: Polarisator
- 14: Welle
- 16: Spiegel

- 20: Sensorelement
- 22: Empfangselement
- 22a: Empfangselement
- 22b: Empfangselement
- 22c: Empfangselement
- 22d: Empfangselement
- 23: Träger
- 24: polarisierende Struktur
- 24a: polarisierende Struktur
- 24b: polarisierende Struktur
- 24c: polarisierende Struktur
- 24d: polarisierende Struktur
- 25: pn-Übergang
- 26: Kontaktanschluss
- 27: Streifen

- 40: Strahlteiler

## Patentansprüche

1. Vorrichtung zur Messung des Drehwinkels zweier relativ zueinander um eine Drehachse rotierender Objekte, mit einer dem einen Objekt zugeordneten Lichtquelle (10), die unpolarisiertes Licht aussendet, mit einem Polarisator (12), wobei sich die Lichtquelle (10) und der Polarisator (12) in Abhängigkeit vom Drehwinkel relativ zueinander drehen, und mit einem Empfänger, der die durch den Polarisator (12) durchtretende oder reflektierte Lichtintensität misst, um ein drehwinkelabhängiges Signal zu erzeugen,
wobei der Empfänger als optoelektronisches Sensorelement (20) ausgebildet ist mit wenigstens einem Empfangselement (22, 22a, 22b, 22c, 22d), vor welchem eine polarisierende Struktur (24, 24a, 24b, 24c, 24d) angeordnet ist, welche aus einem elektrisch leitfähigen Material gefertigt ist, **dadurch gekennzeichnet, dass** die polarisierende Struktur (24, 24a, 24b, 24c, 24d) einen Kontaktanschluss (26) zum Anlegen eines definierten Potentials aufweist und dass die polarisierende Struktur (24, 24a, 24b, 24c, 24d) als Abschirmung des Sensorelements (20) ausgebildet ist.

2. Vorrichtung zur Messung des Drehwinkels nach einem der vorhergehenden Ansprüche,
**dadurch gekennzeichnet, dass** die polarisierende Struktur (24, 24a, 24b, 24c, 24d) aus elektrisch leitfähigen Streifen (27) ausgebildet ist.

3. Vorrichtung zur Messung des Drehwinkels nach einem der vorhergehenden Ansprüche,
**dadurch gekennzeichnet, dass** die polarisierende Struktur (24, 24a, 24b, 24c, 24d) als Drahtgitter-Polarisator ausgebildet ist.

4. Vorrichtung zur Messung des Drehwinkels nach Anspruch 3,
**dadurch gekennzeichnet, dass** der Drahtgitter-Polarisator leitende Streifen (27) aufweist, deren Breite kleiner als die Wellenlänge des Lichts ist und in einem Raster angeordnet sind, das doppelt so groß ist, wie die Streifenbreite.

5. Vorrichtung zur Messung des Drehwinkels nach einem der vorhergehenden Ansprüche,
**dadurch gekennzeichnet, dass** die polarisierende Struktur (24, 24a, 24b, 24c, 24d) aus Aluminium oder einer Aluminiumlegierung gefertigt ist.

6. Vorrichtung zur Messung des Drehwinkels nach einem der vorhergehenden Ansprüche,
**dadurch gekennzeichnet, dass** der Kontaktanschluss elektrisch leitend mit dem Massepotential verbunden ist.

7. Vorrichtung zur Messung des Drehwinkels nach einem der vorhergehenden Ansprüche,
**dadurch gekennzeichnet, dass** der Kontaktanschluss (26) als Anschlussfläche ausgebildet ist.

8. Vorrichtung zur Messung des Drehwinkels nach einem der vorhergehenden Ansprüche,
**dadurch gekennzeichnet, dass** wenigstens eine Gruppe mit wenigstens zwei Empfangselementen (22a, 22b, 22c, 22d) vorhanden ist, vor welchen jeweils eine polarisierende Struktur (24a, 24b, 24c, 24d) angeordnet ist, wobei die Polarisationsebenen der Empfangselemente (22a, 22b, 22c, 22d) in der Gruppe jeweils gegeneinander verdreht sind, vorzugsweise um 180°/n, wobei n die Zahl der Empfangselemente (22a, 22b, 22c, 22d) der Gruppe ist.

9. Vorrichtung nach Anspruch 1,
**dadurch gekennzeichnet, dass** die Lichtquelle (10) und der Empfänger mit der gleichen elektrischen Modulationsfrequenz beaufschlagbar sind.

10. Vorrichtung nach Anspruch 1 oder 9,
**dadurch gekennzeichnet, dass** hinter dem Polarisator (12) ein Spiegel (16) angeordnet ist, welcher senkrecht zur Drehachse angeordnet ist.

11. Vorrichtung nach einem der Ansprüche 1 oder 9 bis 10,
**dadurch gekennzeichnet, dass** im Strahlengang ein Strahlteiler (40) angeordnet ist.

## Claims

1. Device for measuring the angle of rotation between two objects rotating relatively to one another about an axis of rotation, with a light source (10) associated to one of the objects that emits unpolarized light, a polarizer (12), wherein the light source (10) and the polarizer (12) rotate relative to each another depending on the rotation angle, and with a receiver which measures the light intensity passing through or reflected by the polarizer (12), in order to produce a rotation angle signal, wherein the receiver is formed as an optoelectronic sensor element (20) having at least one receiving member (22d, 22, 22a, 22b, 22c), in front of which a polarizing structure (24, 24a, 24b, 24c, 24d) is arranged which is made from an electrically conductive material **characterized in that** the polarizing structure (24 , 24a, 24b , 24c, 24d) has a contact terminal (26) for applying a defined potential, and **in that** the polarizing structure (24, 24a, 24b, 24c, 24d) is formed to shield the sensor element (20).

2. Device for measuring the angle of rotation according to one of the preceding claims, **characterized in that** the polarizing structure (24, 24a, 24b, 24c, 24d) is formed from electrically conductive strips (27).

3. Device for measuring the angle of rotation according to one of the preceding claims, **characterized in that** the polarizing structure (24, 24a, 24b, 24c, 24d) is formed as a wire grid polarizer.

4. Device for measuring the angle of rotation according to claim 3, **characterized in that** the wire grid polarizer having conductive strips (27) whose width is smaller than the wavelength of light and are arranged in a grid that is twice as large as the stripe width.

5. Device for measuring the angle of rotation according to one of the preceding claims, **characterized in that** the polarizing structure (24, 24a, 24b, 24c, 24d) is made of aluminum or an aluminum alloy.

6. Device for measuring the angle of rotation according to one of the preceding claims, **characterized in that** the contact terminal is electrically connected to the ground potential.

7. Device for measuring the angle of rotation according to one of the preceding claims, **characterized in that** the contact terminal (26) is formed as a pad.

8. Device for measuring the angle of rotation according to one of the preceding claims, **characterized in that** at least one group having at least two receiving elements (22a, 22b , 22c, 22d) is provided, in front of which a polarizing structure (24d, 24a, 24b, 24c) is arranged and the planes of polarization of the receiving elements (22a, 22b, 22c, 22d) in the group are rotated against each other, preferably by 180 °/n, whereby n is the number of the receiving elements (22a, 22b, 22c, 22d) of the group.

9. Device according to claim 1, **characterized in that** the light source (10) and the receiver can be acted upon electrically with the same modulation frequency.

10. Device according to claim 1 or 9, **characterized in that** downstream of the polarizer (12) a mirror (16) is arranged, which is perpendicular to the axis of rotation.

11. Device according to one of claims 1 or 9 to 10 **characterized in that** a beam splitter (40) is arranged in the beam path.

## Revendications

1. Dispositif de mesure de l'angle de rotation entre deux objets en rotation relativement à l'autre autour d'un axe de rotation, avec une source de lumière (10) associée à un des l'objets qui émet de la lumière non polarisée, un polariseur (12), dans lequel la source de lumière (10) et le polariseur (12) en tournent par rapport à l'autre en fonction de l'angle de rotation, et avec un récepteur qui mesure l'intensité de lumière passant à travers ou réfléchie par le polariseur (12), afin de produire un signal d'angle de rotation, dans lequel le récepteur est réalisé sous la forme d'un élément capteur opto-électronique (20) présentant au moins une pièce de réception (22d, 22, 22a, 22b, 22c), en face de laquelle une structure de polarisation (24, 24a, 24b, 24c, 24d) est disposée qui est réalisée en un matériau conduite électriquement, **caractérisé en ce que** la structure de polarisation (24, 24a, 24b, 24c, 24d) a une borne de contact (26) pour appliquer un potentiel défini, et **en ce que** la structure de polarisation (24, 24a, 24b, 24c, 24d) est formée pour faire écran à l'élément de capteur (20).

2. Dispositif de mesure de l'angle de rotation selon l'une des revendications précédentes, **caractérisé en ce que** la structure de polarisation (24, 24a, 24b, 24c, 24d) est formée à partir de bandes électriquement conductibles (27).

3. Dispositif de mesure de l'angle de rotation selon l'une des revendications précédentes, **caractérisé en ce que** la structure de polarisation (24, 24a, 24b, 24c, 24d) est formée en tant que polariseur à grille de fils.

4. Dispositif de mesure de l'angle de rotation selon la revendication 3, **caractérisé en ce que** le fil polariseur à grille ayant des bandes conductibles (27) dont la largeur est plus petite que la longueur d'onde de la lumière et qui sont disposées dans une grille qui est deux fois plus grande que la largeur de raie.

5. Dispositif de mesure de l'angle de rotation selon l'une des revendications précédentes, **caractérisé en ce que** la structure de polarisation (24, 24a, 24b, 24c, 24d) est faite d'aluminium ou d'un alliage d'aluminium.

6. Dispositif de mesure de l'angle de rotation selon l'une des revendications précédentes, **caractérisé en ce que** la borne de contact est connectée électriquement au potentiel de masse.

7. Dispositif de mesure de l'angle de rotation selon l'une des revendications précédentes, **caractérisé en ce que** la borne de contact (26) est réalisée sous la forme d'une surface.

8. Dispositif de mesure de l'angle de rotation selon l'une des revendications précédentes, **caractérisé en ce qu'**au moins une groupe ayant au moins deux éléments de réception (22a, 22b , 22c , 22d) est prévue, en face de laquelle une structure de polarisation (24d, 24a, 24b, 24c) est disposée et les plans de polarisation des éléments de réception (22a, 22b , 22c, 22d) dans le groupe sont mis en rotation l'un contre l'autre, de préférence de 180 °/n, n étant le numéro de la réception des éléments (22a, 22b, 22c, 22d) du groupe.

9. Dispositif selon la revendication 1, **caractérisé en ce que** la source de lumière (10) et le récepteur peuvent être donnés avec la même fréquence de modulation electrique.

10. Dispositif selon la revendication 1 ou 9, **caractérisé en ce qu'**en aval du polariseur (12), un miroir (16) est disposé, qui est perpendiculaire à l'axe de rotation.

11. Dispositif selon l'une des revendications 1 ou 9 à 10, **caractérisé en ce qu'**un diviseur de faisceau (40) est disposé dans le trajet du faisceau.
